# FASCICULE DE BREVET EUROPEEN

(11) **EP 1 982 371 B1**
(45) Date de publication et mention de la délivrance du brevet: **28.10.2009**
(21) Numéro de dépôt: 07731498.7
(22) Date de dépôt: 15.01.2007
(51) Int. Cl.: H01M 4/88, C23C 16/04

(54) **PROCÉDÉ DLI-MOCVD POUR LA FABRICATION D'ÉLECTRODES POUR RÉACTEURS ÉLECTROCHIMIQUES**
DLI-MOCVD-VERFAHREN ZUR HERSTELLUNG VON ELEKTRODEN FÜR ELEKTROCHEMISCHE REAKTOREN
DLI-MOCVD PROCESS FOR MAKING ELECTRODES FOR ELECTROCHEMICAL REACTORS

(30) Priorité: 03.02.2006 FR 0650399
(43) Date de publication de la demande: 22.10.2008
(73) Titulaire: COMMISSARIAT A L'ENERGIE ATOMIQUE, 75015 Paris (FR)
(72) Inventeur: MAILLEY, Sophie, F-38730 Le Pin (FR); CAPRON, Philippe, F-38200 Luzinay (FR); THOLLON, Stéphanie, F-38250 Saint Nizier Du Moucherotte (FR); KREBS, Thierry, F-38400 Le Versoud (FR)
(74) Mandataire: Vuillermoz, Bruno
(86) Numéro de dépôt international: PCT/FR2007/050651
(87) Numéro de publication internationale: WO 2007/088292

(56) Documents cités:
- US-A1- 2002 049 134
- US-A1- 2004 167 014
- THOLLON S ET AL: "PULSED LIQUID INJECTION METALORGANIC CHEMICAL VAPOR DEPOSITION OF METALLIC NANOSTRUCTURED CATALYSTS. EVALUATION OF THEIR DEVOC CATALYTIC PROPERTIES" MEETING ABSTRACTS, ELECTROCHEMICAL SOCIETY, PENNINGTON, NJ, US, 2005, page 87, XP008065077 ISSN: 1091-8213
- ADORA S ET AL: "Electrocristallization of platinum nanoparticles supported on carbon analyzed with standard and anomalous X-ray diffraction" JOURNAL OF CRYSTAL GROWTH, ELSEVIER, AMSTERDAM, NL, vol. 275, no. 1-2, 15 février 2005 (2005-02-15), pages e2207-e2210, XP004823571 ISSN: 0022-0248
- GOTO T ET AL: "Electrochemical properties of iridium-carbon nano composite films prepared by MOCVD" SCRIPTA MATERIALIA, ELSEVIER, AMSTERDAM, NL, vol. 44, no. 8-9, 18 mai 2001 (2001-05-18), pages 1187-1190, XP004327534 ISSN: 1359-6462
- SERP P ET AL: "CONTROLLED-GROWTH OF PLATINUM NANOPARTICLES ON CARBON NANOTUBES OR NANOSPHERES B MOCVD IN FLUIDIZED BED REACTOR" JOURNAL DE PHYSIQUE IV, EDITIONS DE PHYSIQUE. LES ULIS CEDEX, FR, vol. 12, no. 4, juin 2002 (2002-06), pages PR4-29, XP009062695 ISSN: 1155-4339
- AKSOYLU A E ET AL: "Highly dispersed activated carbon supported platinum catalysts prepared by OMCVD: a comparison with wet impregnated catalysts" APPLIED CATALYSIS A: GENERAL, ELSEVIER SCIENCE, AMSTERDAM, NL, vol. 243, no. 2, 10 avril 2003 (2003-04-10), pages 357-365, XP004418256 ISSN: 0926-860X

## Description

### DOMAINE TECHNIQUE

L'invention concerne le domaine des réacteurs électro-chimiques comme les piles à combustibles ou les accumulateurs, et plus particulièrement celui des électrodes mises en oeuvre au sein de telles piles. Elle se rapporte plus spécifiquement au dépôt de particules catalytiques constituant la partie active des électrodes de piles à combustible, de type PEMFC (*Proton Exchange Membrane Fuel Cell*)*.*

Selon l'invention, ce dépôt est réalisé par le procédé DLI-MOCVD (pour « *Direct Liquid Metal Organic Chemical Vapor Deposition* »), ce qui permet d'immobiliser les particules catalytiques directement sur les composants support conducteur électronique (GDL pour « *Gas Diffusion Layer* » - couche de diffusion des gaz), et ainsi d'optimiser l'utilisation de la charge en catalyseur immobilisée et de rendre favorable l'organisation de la couche catalytique à l'électrocatalyse.

Ce procédé, qui permet de contrôler la charge en particules catalytiques immobilisées et la morphologie des particules, peut être aisément industrialisé et développé en production de masse d'électrodes pour piles à combustible puisqu'il est compatible avec les procédés de dépôt en continu.

Les électrodes ainsi obtenues présentent une structure unique, le catalyseur se présentant sous forme de nanoparticules dispersées directement sur la couche de diffusion.

De façon plus large, l'invention se rapporte à tout matériau d'électrode utilisé pour des systèmes de piles à combustible et de batteries dans la génération d'énergie.

### ETAT DE LA TECHNIQUE

Le matériau constitutif des électrodes d'une pile à combustible fonctionnant à basse température (PEMFC, DMFC, pile alcaline à membrane solide) est réalisé sur un support de carbone de base tissu, papier ou feutre de carbone, qui joue le rôle de support de couche de diffusion et assure la tenue mécanique de l'électrode.

Les propriétés de conduction électronique du matériau d'électrode et du matériau de diffusion des gaz proviennent de ce matériau support et des encres ou pâtes de carbone introduites mécaniquement ou pulvérisées en surface du support de couche de diffusion pour former le réseau de percolation des charges.

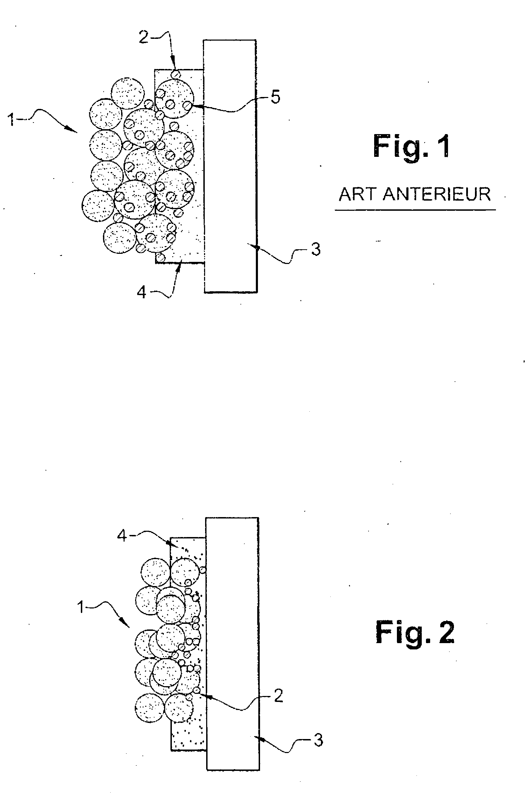

On a représenté en relation avec la figure 1 une vue schématique d'un assemblage d'une électrode du type en question de l'état antérieur de la technique. Une pulvérisation de microporeux de carbone **1** est généralement réalisée sur l'une des faces de la couche de diffusion pour supporter la couche catalytique et assurer une bonne diffusion des gaz.

La couche catalytique est un élément fondamental dans l'assemblage membrane - électrodes. Par la présence de particules catalytiques **2** (platine ou autres métaux nobles), les réactions d'oxydation de l'hydrogène et de réduction de l'oxygène mises en oeuvre au sein des piles à combustibles, viennent prendre place de part et d'autre de la membrane séparatrice conductrice protonique **3** et permettent ainsi la génération d'électrons.

La formulation de la couche catalytique avec de faibles charges en métaux nobles s'inscrit comme l'un des facteurs clés du développement des piles à combustible de type PEMFC. En effet, plusieurs études économiques menées au début des années 2000 ont montré que le platine introduit dans les couches catalytiques et la mise en forme de celles-ci constituaient le deuxième composant le plus coûteux dans la pile. Une connaissance des transferts physico-chimiques et électrochimiques intervenant au sein des matériaux d'électrodes montre que la diminution du taux de particules catalytiques dans la pile ne peut se faire que par une optimisation de la morphologie de la zone catalytique.

Les procédés de mise en forme de couche active les plus couramment rapportés dans la littérature, reposent sur le principe de dépôt, sur la couche de diffusion, d'un spray de particules de C/Pt mises en suspension dans un solvant léger, tel que de l'alcool, et incorporant un liant polymère, ce dernier assurant la tenue mécanique et la gestion de l'eau. Sur les vingt dernières années, une forte diminution des charges en platine dans le matériau d'électrode a été réalisée.

Cette diminution a été liée à l'association de nanoparticules de platine immobilisées sur du carbone **5** et à l'utilisation de film d'imprégnation de conducteur protonique **4.** Ainsi, le site catalytique devient actif car il intègre directement au contact de la particule, le réseau de conduction protonique et le réseau de percolation des charges électroniques. Cette zone est active dans la limite de l'accessibilité du combustible ou du gaz oxydant, c'est-à-dire qu'elle est limitée par l'apport de matière.

Dans les réalisations actuelles, telles qu'illustrées au sein de la Figure 1, la morphologie de la couche active n'est malheureusement pas optimale. En effet, seuls 50 à 75% du platine introduit dans ces couches actives est reconnu comme électroactif. Cette perte d'électroactivité est liée à la mauvaise répartition du catalyseur. Les différentes sources de limitation s'expliquent comme suit :
- soit par un transfert de charge électronique non optimum, le réseau de percolation des carbones n'étant alors pas continu, de la particule de C/Pt à la couche de diffusion et au travers de cette dernière jusqu'aux plaques bipolaires ;
- soit par un transport de matière limitant, la particule catalytique n'étant pas atteinte par le gaz (si par exemple le platine se retrouve en vis-à-vis avec la particule de carbone) ;
- soit par un réseau de conduction des protons (obtenu par imprégnation avec une solution de conducteur protonique ou par contact de l'électrode avec la membrane) ne permettant pas d'atteindre la particule catalytique.

Des formulations optimales de couches actives sur support de couche de diffusion ont été décrites. Plus particulièrement, la formulation des électrodes E-Tek, commercialisées par DeNora, est rapportée dans les documents EP-A-0 872 906 et EP-A-0 928 036.

Dans la littérature, il est mis en évidence la possibilité d'accroître les performances des piles en jouant sur les modes d'incorporation du conducteur protonique. Par une optimisation du taux de Nafion incorporé dans la couche active, le domaine cinétique de fonctionnement de la pile à combustible (domaine des faibles densités de courant) peut être amélioré. Cependant, pour de très faibles charges en platine, cette amélioration agit au détriment du domaine des fortes densités de courant, avec une limitation par le transfert de matière plus rapidement atteinte, et une augmentation des résistances d'interface électrode - membrane.

Les couches actives ont fait l'objet de plusieurs modélisations visant à déterminer leur organisation optimale, en augmentant la surface géométrique du platine développée et en minimisant les effets de résistance liés au conducteur protonique et au carbone. Basées sur ces modélisations, de nouvelles structures ont été testées, introduisant soit des structures multicouches (alternance de couche catalytique et de film conducteur protonique), soit des fibres imprégnées de conducteur protonique, soit des porophores. Les résultats les plus satisfaisants ont été obtenus par l'introduction de systèmes porophores dans les couches actives, comme décrit dans le document US 2001/0031389. Le transport de matière est amélioré, permettant ainsi de répondre aux demandes d'application de fonctionnement sous air des piles.

De manière convergente avec l'idée d'une couche active plus ouverte pour ne pas limiter le transport de matière et renforcer le réseau de percolation des charges électroniques, la possibilité d'immobiliser directement les particules catalytiques sur le support de couche de diffusion a été développée.

Ce type de réalisation est rapporté dans la littérature avec différentes techniques : électrodéposition pulsée, microémulsion, pulvérisation, dépôts sous vide (EBPVD dans le document US - 6 610 436, CCVD décrit dans le document WO 03/015199). Cependant, ces différentes techniques présentent des inconvénients non négligeables.

Les réalisations avec microémulsion ne permettent pas d'obtenir une répartition contrôlée des particules si on dépose directement sur couche de diffusion.

Dans le cas des dépôts par électrodéposition, les tailles de particules obtenues sont généralement supérieures à 50 nm et présentent donc une électroactivité faible.

Pour les dépôts par PVD, la limitation à ce type de réalisation réside dans la difficulté d'obtenir des nanodispersions de nanoparticules catalytiques et d'avoir une localisation des catalyseurs au voisinage de la membrane, sans perdre une certaine profondeur permettant de répondre à une activité catalytique plus importante lors des appels de puissance.

Les réalisations par "ion - beam", telles que décrites dans le document US-6 673 127, ne permettent pas d'assurer une dispersion en profondeur, dans plus de 5 nm d'épaisseur de la couche de diffusion.

Le procédé de dépôt par CVD standard présente un rendement de croissance de particules trop faible pour les températures de dépôt requises par les supports d'électrodes (T < 350°C), ou nécessite l'utilisation de précurseurs alicycliques de platine (voir le document US-6 162 712) malheureusement très instables en température et sous air.

Il apparaît donc clairement que les couches catalytiques actuellement présentes dans les piles à combustible de type PEMFC, illustrées à la Figure 1, présentent l'inconvénient d'immobiliser une forte charge de catalyseur qui reste inaccessible au réseau de conduction protonique et de diffusion des gaz, ou bloquante pour la conduction électronique.

Le document US2002/049134, décrit aussi: un procédé de fabrication d'électrode pour réacteur électrochimique, ladite électrode comprenant une couche de diffusion ("carbonaceous material"), et une couche catalytique (Pt), caractérisée en ce que l'étape de dépôt du catalyseur sur la couche de diffusion est réalisée selon un procédé classique de dépôt sous vide et en ce que la couche de diffusion est réalisée en carbone poreux, pouvant être des nanotubes de carbone.

Le document THOLLON S ET AL: "PULSED LIQUID INJECTION METALORGANIC CHEMICAL VAPOR DEPOSITION OF METALLIC NANOSTRUCTURED CATALYSTS. EVALUATION OF THEIR DEVOC CATALYTIC PROPERTIES" MEETING ABSTRACTS, ELECTROCHEMICAL SOCIETY, PENNINGTON, NJ, US, 2005, page 87, XP008065077 ISSN: 1091-8213, décrit le dépôt d'un catalyseur (Pt) par DU-MOVD, afin d'obtenir une bonne dispersion en contrôlant précisément la répartition des nanoparticules sur un support poreux (pouvant être par exemple des "ceramic honeycombs"), dans le but d'une optimisation des performances catalytiques.

Il existe donc un besoin évident d'obtenir des nouvelles structures de couche catalytique ne présentant pas l'ensemble des inconvénients mentionnés ci-dessus et donc d'identifier une technologie de dépôt permettant cette réalisation.

### DESCRIPTION DE L'INVENTION

Ainsi, selon un premier aspect, l'invention concerne un procédé de fabrication d'électrodes de pile à combustible.

Les électrodes de piles à combustible se définissent comme le siège des réactions électrochimiques (oxydation à l'anode et réduction à la cathode), lesdites réactions n'étant possibles qu'en présence d'un catalyseur. En pratique, de telles électrodes comprennent un support servant à la tenue mécanique comprenant au moins une couche microporeuse conductrice électronique, également appelée couche de diffusion, et recouverte d'une couche catalytique et éventuellement en contact avec un film conducteur protonique.

Le procédé selon l'invention se caractérise en ce que l'étape de dépôt du catalyseur sur la couche de diffusion est réalisée par DLI-MOCVD, et en ce que ladite couche de diffusion est réalisée en carbone poreux.

La mise en oeuvre du procédé DLI-MOCVD a certes été rapportée dans le journal Microelectronic Engineering (64 (2002) pp 457-463), mais uniquement pour l'obtention de films de platine continus dans les applications relatives à la ferroélectricité.

En revanche et dans le cadre de l'invention, cette technologie génère des nanoparticules de catalyseur, en dispersion nanométrique et avec un taux de croissance rapide, que les techniques de dépôt utilisées antérieurement ne permettaient pas d'obtenir. De ce fait, selon un second aspect, sont également visées par l'invention des électrodes pour pile à combustible présentant des nanoparticules de catalyseur dispersées en contact direct avec la couche de diffusion.

Dans le cadre de l'invention, le type de support sur lequel sont formées ces nanoparticules est important pour permettre d'éviter la formation d'un film continu. Plus particulièrement, la microporosité des couches superficielles des électrodes de diffusion des gaz doit être prise en compte pour la structure finale du matériau d'électrode.

Ainsi, le carbone poreux de la couche de diffusion sur laquelle est effectué le dépôt est réalisé par exemple en carbone, en graphite ou par des nanotubes. Le carbone peut être de type Vulcan XC 72 ou de type Shawanagan.

Pour assurer un bon fonctionnement électrochimique, il faut aussi mettre en contact le conducteur protonique avec le catalyseur. Dans l'art antérieur, pour finaliser la fabrication du matériau d'électrode, le conducteur protonique est pulvérisé en spray dans une solution alcoolisée recouvrant ainsi les zones de répartition des particules catalytiques. Selon l'invention, il est possible de déposer les particules catalytiques sur une couche microporeuse présentant le conducteur protonique. Par exemple, on a déposé par DLI-MOCVD des particules de platine sur une couche de carbone présentant une charge équivalente en Nafion^{®} de 0,4 mg/cm² par l'intermédiaire d'un précurseur Pt(COD) dilué dans un solvant (toluène) sous une température de 210°C. Cette couche microporeuse peut être déposée par spray d'une solution de particules de carbone mélangées avec un conducteur protonique solubilisé. Le conducteur protonique filmogène peut ou non être de la même structure que la membrane séparatrice dans la pile.

De manière classique, le catalyseur est avantageusement choisi dans le groupe des métaux nobles, préférentiellement du platine (Pt). Les particules catalytiques déposées sont préférentiellement monométalliques.

Par ailleurs, l'immobilisation de nanoparticules de platine par le procédé d'injection liquide d'organométalliques par CVD (DLI-MOCVD) peut être réalisée à haute température, permettant ainsi une bonne accroche des particules sur le substrat. Selon l'invention, le dépôt est donc réalisé à une température préférentiellement comprise entre 200 et 350°C.

En effet, pour les matériaux d'électrode se pose le problème de leur vieillissement et de l'adhérence des dépôts. Des études ont montré que le vieillissement des matériaux se traduisait par une perte du catalyseur par élution. L'interface des électrodes de pile à combustible étant en contact avec une circulation d'eau issue soit de la catalyse de réduction de l'oxygène, soit de l'humidification des gaz, la stabilité d'adhérence des particules de platine est requise. La réalisation des couches actives par spray étant effectuée à des températures assez faibles (<200°C), l'adhérence de ce type de structure est discutable malgré les étapes *a posteriori* de pressage à chaud sur la membrane. Il est donc justifié d'envisager un mode de réalisation de particules à plus haute température sur une structure présentant une bonne cohésion *a posteriori* sans dépasser la température limite du support d'électrode de l'ordre de 350°C. La technologie DLI-MOCVD est tout à fait compatible avec cette gamme de températures.

La présence sur la couche de diffusion de conducteur protonique, matériau dont la sensibilité en température est bien connue, implique que le procédé d'immobilisation de la couche catalytique fasse appel à des dépôts basse température, soit par l'utilisation de précurseurs spécifiques des basses températures, soit par l'utilisation du procédé d'activation de dépôt par plasma (PECVD).

Le principe de la DLI-MOCVD est issu des systèmes classiques de CVD. Les espèces réactives sont apportées sous forme liquide et injectées à haute pression par des injecteurs. Ainsi, partant d'une solution de précurseur dilué, la consommation en produit est réduite et peut être contrôlée en volume ou masse. Ce procédé permet donc de contrôler la morphologie des particules en fonction des paramètres d'élaboration (la masse de produit injecté, la fréquence d'injection, le solvant du précurseur et le temps de dépôt) et assure une réalisation rapide et industrialisable.

En pratique, la synthèse des nanoparticules catalytiques est réalisée par DLI-MOCVD à pression atmosphérique ou sous vide (de 1 000 Pa jusqu'à 70 Pa sous mélange N₂-O₂ ou H₂-N₂), avec une température de dépôt inférieure ou égale à 500°C, à partir d'un mélange de précurseurs tels que les organométalliques (type β-diacétonates, carboxylates) solubles dans un solvant commun (acétyl acétone, THF, ...), ou à partir de plusieurs sources indépendantes de précurseurs, en présence d'un gaz réactionnel composé en majorité d'un gaz réactif oxydant (par exemple O₂, CO₂...) ou réducteur (H₂).

Pour concorder avec des propriétés de tenue en température des composés polymères, des précurseurs basse température, tels que les organométalliques présentant des groupements de type arène COT ou COD (PtCOD, PtMe2Cp, ...), sont utilisés aux moyennes températures de dépôt (< 350°C).

Comme déjà mentionné, le procédé de fabrication selon l'invention permet de tendre vers une structure idéale, dans laquelle les particules catalytiques **2** sont directement fixées sur le support de conducteur électronique qui joue le rôle de la couche de diffusion des gaz **1** (Figure 2). Ainsi, la zone de catalyse correspond effectivement au domaine dénommé "point de contact triple", où viennent prendre place les échanges électroniques, la consommation de réactif gazeux et le transfert d'espèces ioniques.

Ce procédé permet d'obtenir une organisation bien particulière de la couche de catalyse. L'électrode présente des particules de catalyseur dispersées en contact direct avec la couche de diffusion.

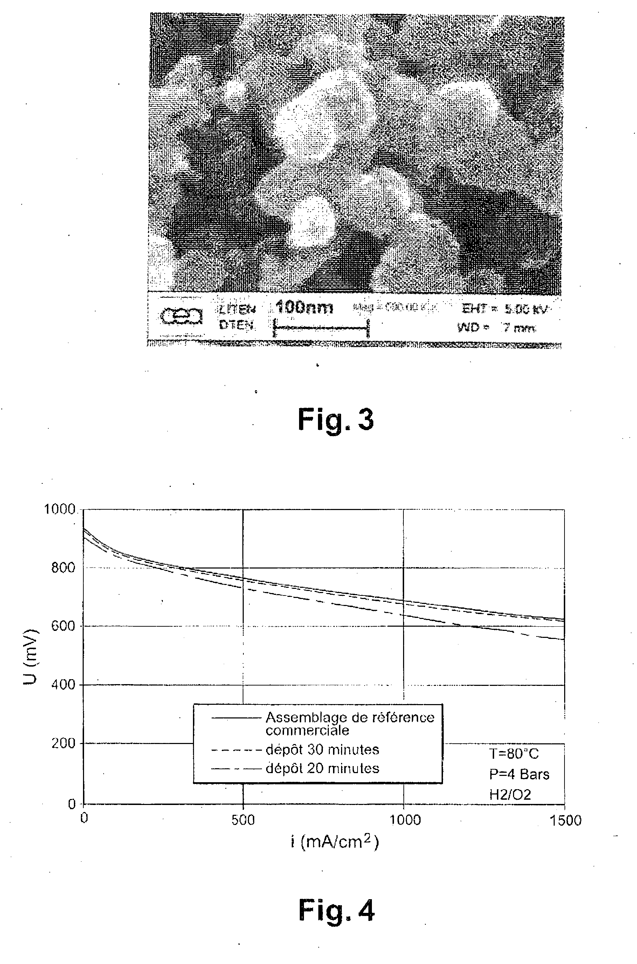

Plus précisément et comme illustré à la Figure 3, on observe des îlots métalliques de taille nanométrique (diamètre inférieur à 50 nm, préférentiellement entre 1 et 20 nm), dispersés de façon homogène avec une distance inter-particulaire de 2 à 30 nm en surface du support microporeux que forme la couche de diffusion.

La répartition des particules catalytiques est d'autant plus intéressante que le conducteur protonique peut être mis en contact avec celles-ci. Ainsi et de façon avantageuse, la formulation du microporeux support du dépôt de particules intègre un certain taux de conducteur protonique, de préférence de la même composition que celui constituant la membrane électrolyte. Pour faciliter les propriétés de germination des particules déposées, un pré-traitement de surface par plasma gazeux peut être réalisé.

Le procédé de déposition par DLI-MOCVD permet d'assurer une bonne infiltration (supérieure à 5 µm) des particules déposées sur des structures micro et nanoporeuses. Ainsi, des profondeurs de pénétration d'environ 100 µm peuvent être obtenues à l'aide du procédé selon l'invention, alors que les procédés de l'art antérieur ne permettaient que des pénétrations de quelques micromètres, voir par exemple la publication de Brault et al. dans le Journal of Physics D : Applied Physics (37 (2004) pp 3419-23).

La pénétration dans le microporeux se répartit en un gradient de concentration décroissant depuis la surface de ladite couche, ce qui permet de répondre aux différentes conditions d'appels de puissance du réacteur électrochimique.

De par la nature chimique des particules déposées (métaux nobles ou oxydes métalliques) et de la morphologie des dépôts (grand nombre de sites actifs de taille nanométrique très bien dispersés), les couches actives mises en oeuvre dans la présente invention apparaissent comme hautement performantes pour l'électrocatalyse des réactions générées au sein des piles à combustible. Ces performances permettent d'obtenir des électrodes présentant des charges en catalyseur, en particulier en platine, inférieure ou égale à 0,2 mg/cm².

Les piles à combustible et les accumulateurs comportant de telles électrodes font également partie de l'invention.

### EXEMPLES DE REALISATION

L'invention et les avantages qui en découlent ressortiront mieux des exemples de réalisation qui suivent, données à titre indicatif et non limitatif à l'appui des figures annexées.
- Figure 1 :: Représentation schématique de l'assemblage membrane/électrode selon l'art antérieur.
- Figure 2 :: Représentation schématique d'un dépôt de catalyseur selon l'invention.
- Figure 3 :: Micrographie d'un dépôt de catalyseur réalisé selon l'invention.
- Figure 4 :: Courbe de polarisation obtenue dans l'exemple de réalisation sous H₂-O₂.
- Figure 5 :: Courbe de polarisation obtenue dans l'exemple de réalisation sous H₂ - air (T = 80°C ; P = 4 bars absolus).
- Figure 6 :: Profil de pénétration du platine dans une couche de diffusion, poreuse en carbone.
- Figure 7 :: Infiltration du platine dans le carbone microporeux, mesuré par analyse X.

Les exemples présentés ci-dessous ont été réalisés à l'aide d'un dispositif de vaporisation commercialisé par la société JIPELEC sous le nom de *"Inject, Système d'injection et d'évaporation de précurseurs liquides purs ou sous forme de solutions",* couplé à une enceinte de dépôt chimique en phase vapeur.

Le dispositif JIPELEC comprend plusieurs parties : le réservoir de stockage de la solution chimique, un injecteur (essence, diesel) relié au réservoir de liquide par une ligne d'alimentation et piloté par un dispositif de commande électronique, une ligne d'alimentation de gaz vecteur, et un dispositif de vaporisation (évaporateur).

L'enceinte de dépôt, qui contient le substrat à revêtir, comprend un système de chauffage, une alimentation de gaz et des moyens de pompage et de régulation de pression. L'enceinte de dépôt, ainsi que le substrat sont portés à une température supérieure à celle de l'évaporateur, de façon à créer un gradient thermique positif.

La solution chimique est introduite dans le réservoir maintenu sous pression (2 bars dans le cas présent), puis envoyée au travers du ou des injecteurs par différence de pression dans l'évaporateur.

Le débit d'injection est contrôlé en fréquence et en durée d'ouverture par l'injecteur.

Ce type d'installation peut aisément être mis dans une chaîne de fabrication en continu de matériau d'électrode.

Le procédé utilisé permet de former de grandes surfaces d'électrode (> 2 500 cm²).

Dans les conditions de dépôt énoncées ci-dessous, les nanoparticules de platine (Pt) sont réalisées sur substrat de couche de diffusion commerciale de type ELAT (produit E-Tek, commercialisé par De Nora).

La solution chimique de dépôt comprend le précurseur organo-métallique de Pt (acétylacétonate), dissout dans un solvant (acétylacétone).

Les températures de l'évaporateur et du substrat sont fixées respectivement à 220 °C et 340°C.

Les autres conditions opératoires des deux exemples sont présentées dans le tableau I suivant :

**Tableau I : Conditions opératoires appliquées pour les essais 1 et 2**

| | Concentration mol/l | Fréquence injecteur (Hz) | durée d'ouverture injecteur (ms) | Débits N₂/O₂ (cc) | Pression (Pa) | durée due dépôt (min) |
|---|---|---|---|---|---|---|
| Essai 1 | 0,03 | 2 | 2 | 40/160 | 800 | 30 |
| Essai 2 | 0,03 | 2 | 2 | 40/160 | 800 | 20 |

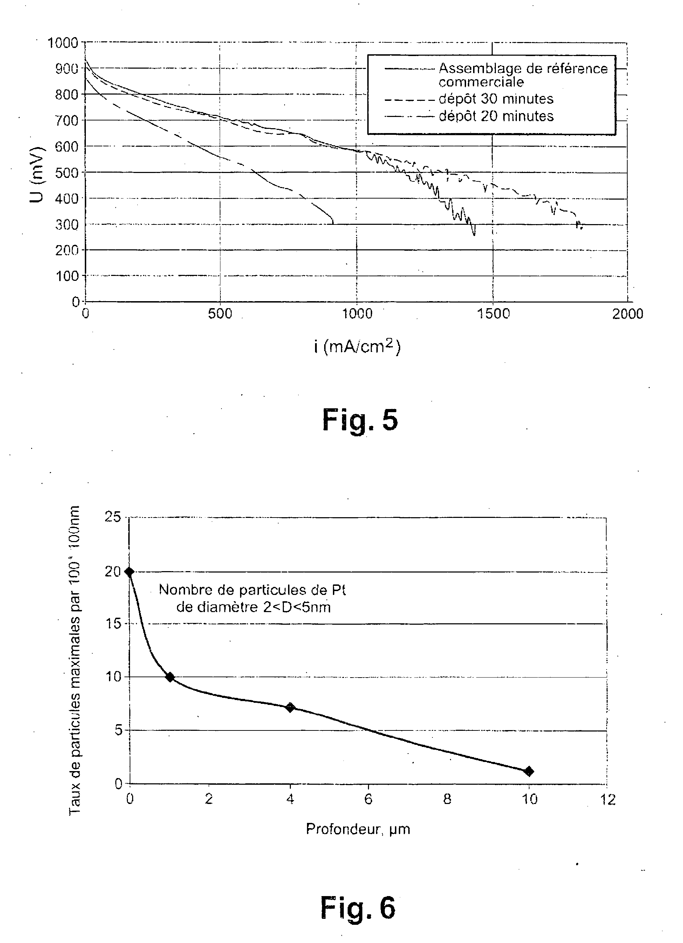

Les courbes de polarisation (figures 4 et 5), obtenues en test pile avec assemblage, concernent des électrodes selon l'invention. Ces courbes montrent une amélioration des transports de matière aux fortes densités de courant sous pression d'air (Fig. 5).

Ce comportement est lié à la structure plus ouverte du matériau d'électrode présentant une couche catalytique plus réduite en épaisseur que les dépôts standards de platine supportés sur carbone.

Le matériau d'électrode selon l'invention est bien adapté à un fonctionnement sous air.

Les performances sous oxygène pur (Fig. 4) sont similaires à celles des produits commerciaux utilisant des catalyseurs de platine supportés sur carbone. Cependant, il est important de noter que les charges en platine sont respectivement de 0,17 mg/cm² pour un dépôt de 30 minutes et 0,11 mg/cm² pour un dépôt de 20 minutes.

Comparativement à des matériaux du commerce réalisés avec des platines supportés sur carbone (charge en platine = 0,35 mg/cm²) la surface électroactive libérée avec une électrode selon l'invention est donc 40% supérieure.

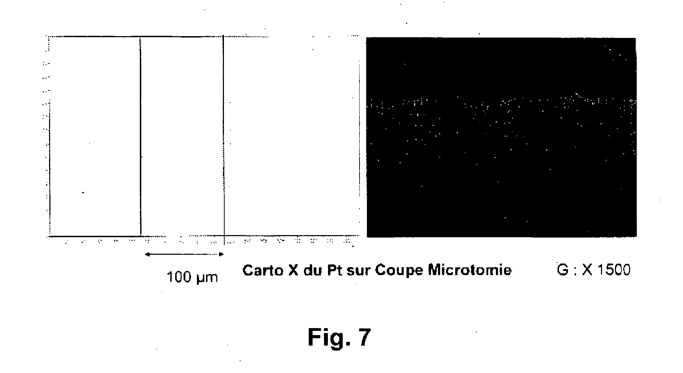

Les figures 6 et 7 illustrent les profils de pénétration du platine dans une couche de diffusion poreuse en carbone.

Plus précisément, la figure 7 illustre une cartographie X du platine sur coupe microtome (grossissement : x 1500). Il s'agit d'une électrode chargée à 0,15 mg/cm² en platine. Le dépôt a été réalisé dans les conditions suivantes : 3,5 Hz ; 30 minutes ; précurseur Pt(COD) = diméthyl 1-5 cyclooctadiène platinium (II) dans du xylène à raison de 0,025 mol/litre, avec un substrat à 244°C et sous 1000 Pa. On constate que l'infiltration du catalyseur dans le carbone microporeux atteint une profondeur d'environ 100 micromètres. Cette profondeur importante illustre l'avantage de la technique DLI-MOCVD par rapport aux autres procédés qui n'autorisaient qu'une pénétration de quelques micromètres.

Le procédé selon l'invention ainsi que les électrodes décrites dans le cadre de cette invention, présentent donc des avantages notoires. Parmi ceux-ci, on peut citer :
■ la fabrication d'électrodes pour pile à combustible PEMFC (*Proton Exchange Membrane Fusel Cell*) à faible charge en catalyseur permettant une réduction des coûts et à haute activité électrocatalytique permettant une augmentation des performances ;
■ la possibilité d'industrialiser un procédé de fabrication en continu ;
■ la possibilité de disposer d'une vitesse de croissance rapide et contrôlable dans le cadre d'un tel dispositif ;
■ la suppression des étapes de post-frittage ou de pressage, nécessaires dans les procédés de l'art antérieur ;
■ l'amélioration des propriétés de transfert de matière ;
■ la formulation de support de couche catalytique intégrant le réseau de percolation des charges électroniques (réseau carboné) et le réseau de transport protonique ;
■ l'amélioration de la tenue du catalyseur grâce au dépôt sous des températures relativement élevées.

## Revendications

1. Procédé de fabrication d'électrode pour réacteur électrochimique, ladite électrode comprenant une couche de diffusion et une couche catalytique, ***caractérisé* en ce que** l'étape de dépôt du catalyseur sur la couche de diffusion est réalisée selon le procédé DLI-MOCVD à une température comprise entre 200 et 350°C, et **en ce que** la couche de diffusion est réalisée en carbone poreux.

2. Procédé de fabrication d'électrode pour réacteur électrochimique selon l'une des revendications précédentes, ***caractérisé* en ce que** le dépôt du catalyseur est réalisé sous pression atmosphérique ou sous vide.

3. Procédé de fabrication d'électrode pour réacteur électrochimique selon l'une des revendications précédentes, ***caractérisé* en ce que** le dépôt du catalyseur par **DLI-**MOCVD est réalisé en utilisant des précurseurs basse température, tels que des organométalliques.

4. Procédé de fabrication d'électrode pour réacteur électrochimique selon l'une des revendications 1 à 2, ***caractérisé* en ce que** le dépôt du catalyseur par DLI-MOCVD est réalisé en utilisant le procédé d'activation de dépôt par plasma (PECVD).

5. Procédé de fabrication d'électrode pour réacteur électrochimique selon l'une des revendications précédents, ***caractérisé* en ce que** le catalyseur est constitué par du platine (Pt).

6. Procédé de fabrication d'electrode pour réacteur électrochimique selon l'une des revendications précédentes, ***caractérisé* en ce que** la couche de diffusion est réalisée en carbone poreux intégrant du conducteur protonique.

7. Procédé de fabrication d'électrode pour réacteur électrochimique selon l'une des revendications précédentes, ***caractérisé* en ce que** le carbone poreux est constitué par des nanotubes de carbone.

## Claims

1. Method for fabricating an electrode for electrochemical reactor, the said electrode comprising a diffusion layer and a catalyst layer, ***characterized* in that** the step of depositing the catalyst on the diffusion layer is carried out by the DLI-MOCVD process at a temperature between 200 and 350°C, and **in that** the diffusion layer is made of porous carbon.

2. Method for fabricating an electrode for electrochemical reactor according to claim *1,* ***characterized* in that** the catalyst is deposited under atmospheric pressure or under vacuum.

3. Method for fabricating an electrode for electrochemical reactor according to one of the preceding claims, ***characterized* in that** the deposition of the catalyst by DLI-MOCVD is carried out using low temperature precursors, such as organometallics.

4. Method for fabricating an electrode for electrochemical reactor according to one of Claims 1 and 2, ***characterized* in that** the deposition of the catalyst by DLI-MOCVD is carried out using the plasma enhanced chemical vapour deposition (PECVD) process.

5. Method for fabricating an electrode for electrochemical reactor according to one of the preceding claims, ***characterized* in that** the catalyst consists of platinum (Pt).

6. Method for fabricating an electrode for electrochemical reactor according to one of the preceding claims, ***characterized* in that** the diffusion layer is made of porous carbon incorporating proton conductor.

7. Method for fabricating an electrode for electrochemical reactor according to one of the preceding claims, ***characterized* in that** the porous carbon consists of carbon nanotubes.

## Patentansprüche

1. Verfahren zur Herstellung einer Elektrode für einen elektrochemischen Reaktor, wobei die Elektrode eine Diffusionsschicht und eine katalytische Schicht umfasst, **dadurch gekennzeichnet, dass** der Schritt des Aufbringens des Katalysators auf die Diffusionsschicht nach dem DLI-MOCVD-Verfahren bei einer Temperatur zwischen 200 und 350°C durchgeführt wird und dass die Diffusionsschicht aus porösem Kohlenstoff hergestellt wird.

2. Verfahren zur Herstellung einer Elektrode für einen elektrochemischen Reaktor nach einem der vorhergehenden Ansprüche, **dadurch gekennzeichnet, dass** die Aufbringung des Katalysators unter atmosphärischem Druck oder unter Vakuum durchgeführt wird.

3. Verfahren zur Herstellung einer Elektrode für einen elektrochemischen Reaktor nach einem der vorhergehenden Ansprüche, **dadurch gekennzeichnet, dass** die Aufbringung des Katalysators durch DLI-MOCVD durchgeführt wird, indem Niedrigtemperatur-Precursor wie Organometalle verwendet werden.

4. Verfahren zur Herstellung einer Elektrode für einen elektrochemischen Reaktor nach einem der Ansprüche 1 bis 2, **dadurch gekennzeichnet, dass** die Aufbringung des Katalysators durch DLI-MOCVD unter Verwendung des Verfahrens der Aktivierung der Aufbringung durch Plasma (PECVD) durchgeführt wird.

5. Verfahren zur Herstellung einer Elektrode für einen elektrochemischen Reaktor nach einem der vorhergehenden Ansprüche, **dadurch gekennzeichnet, dass** der Katalysator aus Platin (Pt) besteht.

6. Verfahren zur Herstellung einer Elektrode für einen elektrochemischen Reaktor nach einem der vorhergehenden Ansprüche, **dadurch gekennzeichnet, dass** die Diffusionsschicht aus porösem Kohlenstoff hergestellt wird, in den ein protonischer Leiter integriert ist.

7. Verfahren zur Herstellung einer Elektrode für einen elektrochemischen Reaktor nach einem der vorhergehenden Ansprüche, **dadurch gekennzeichnet, dass** der poröse Kohlenstoff aus Kohlenstoff-Nanoröhren besteht.
